# EUROPEAN PATENT APPLICATION

(11) **EP 4 501 449 A1**
(43) Date of publication of application: **05.02.2025**
(21) Application number: 23780240.0
(22) Date of filing: 24.03.2023
(51) Int. Cl.: B01J 23/10, B01J 35/02, B01J 37/025, C23C 14/08, C23C 14/34

(54) **PHOTOCATALYST MEMBER**

(30) Priority: 30.03.2022 JP 2022056768
(71) Applicant: Dexerials Corporation, Shimotsuke-shi, Tochigi 323-0194 (JP)
(72) Inventor: WAKO Hitoshi, Shimotsuke-shi, Tochigi 323-0194 (JP)
(74) Representative: Lavoix
(86) International application number: PCT/JP2023/011976
(87) International publication number: WO 2023/190230

(57) **Abstract**

According to one aspect of the present invention, what is provided is a photocatalyst member in which a photocatalyst layer is formed on a substrate via an underlayer, the underlayer contains at least cerium oxide, and the photocatalyst layer contains at least titanium oxide. Here, the underlayer may be composed solely of the cerium oxide or composed of the cerium oxide and at least one or more other elements at 10 atomic% or less of an elemental cerium proportion. According to the present invention, it is possible to produce a highly productive photocatalyst industrially.

## Description

### TECHNICAL FIELD

The present invention relates to a photocatalyst member.

Priority is claimed on Japanese Patent Application No. 2022-056768, filed March 30, 2022, the content of which is incorporated herein by reference.

### BACKGROUND ART

Photocatalysts which exhibit catalytic action due to light such as ultraviolet light and visible light are currently attracting attention because of their various effects. Photocatalysts are particularly known to have effects such as property of generating hydrogen and oxygen through photolysis of water as seen in the Honda-Fujishima effect, strong oxidation nature generation of active oxygen on their surface, and superhydrophilicity due to generation of numerous hydroxyl groups on their surface. Photocatalysts are thought to have various applications, such as sterilizing pathogens and viruses such as coronaviruses which have become particularly prevalent through light irradiation, decomposing formaldehyde which causes sick house syndrome, and anti-fogging films using superhydrophilicity.

In addition, when a photocatalyst is applied to an anti-reflection film, it is expected to be effective in decomposing fingerprint marks adhered to the surface of the anti-reflection film. Since the anti-reflection film made of a dielectric multilayer film in which inorganic substances having different refractive indices and especially having a thickness of 1 µm or less are alternately stacked uses light interference, even if slightly transparent foreign substances such as fingerprints adhere to the surface, the interference effect is disrupted, and the transparent foreign substances are likely to be visible. Conventionally, anti-reflection films have been covered with substances such as fluorine compounds with low surface energy to inhibit adhesion of transparent foreign substances such as fingerprint marks, but it cannot be stated that the effect is sufficient, and cleaning such as wiping off is necessary. Since if transparent foreign substances which are organic substances could be decomposed by photocatalysts for such an issue, there would be no need for cleaning, there are high expectations for photocatalysts.

Titanium oxide is known as a material with photocatalytic ability. As a method for forming titanium oxide on the surface of some kind of substrate, a vacuum thin film formation technique such as sputtering is known. However, for titanium oxide to exhibit photocatalytic performance, crystallization of an anatase type or a rutile type is necessary, and heat treatment at 300°C or higher is required during or after film formation for crystallization. For this reason, it is difficult to apply photocatalysts to members such as plastics with low heat resistance. Another method has been proposed in which a crystallized titanium oxide fine powder is applied to a substrate together with a binder and fixed. This coating method is widely used because it does not require treatment such as heating and enables large-area treatment. Most of the photocatalysts currently commercialized are based on this coating method.

### Citation List

### Patent Documents

Patent Document 1: Japanese Unexamined Patent Application, First Publication No. 2007-308729
Patent Document 2: Japanese Unexamined Patent Application, First Publication No. 2007-314835
Patent Document 3: Japanese Patent No. 5217023
Patent Document 4: Japanese Unexamined Patent Application, First Publication No. 2000-345320
Patent Document 5: Japanese Patent No. 4460537

### SUMMARY OF INVENTION

### Technical Problem

However, there is a problem that, because binders used for fixation to substrates are often organic substances and they come into contact with photocatalysts, a phenomenon called chalking will occur, where a binder decomposes and a photocatalyst itself also falls off. In addition, there is a problem that increasing the proportion of a binder to strengthen a bond between a substrate and a photocatalyst will relatively decrease the proportion of the photocatalyst, resulting in lower catalytic performance.

Therefore, it is desirable to form a titanium oxide thin film through a vacuum thin film formation technique that does not involve a binder, but the challenge is how to achieve photocatalytic performance with film formation at room temperature.

As a method for obtaining titanium oxide crystallized at room temperature, Patent Document 1 discloses a method in which the duty ratio of voltage application is set to a certain value or less using a single cathode or a dual cathode. Patent Document 1 states that titanium oxide crystallized through this technique can be obtained, but when the present inventors conducted a reproduction experiment, crystallization could not be confirmed, and it may depend on the configuration or the like of the facility.

In addition, Patent Documents 2 and 3 disclose a method for promoting crystallization through separating formation of a titanium metal film and oxidation treatment into two steps. However, a complex configuration is required for the facility, making it difficult to achieve the crystallization with a general-purpose sputtering device.

As an example using a general-purpose sputtering device, a method has been attempted in which moisture is added during film formation and crystallization is achieved by performing heat treatment at a relatively low temperature (200°C or higher) as shown in Patent Document 4. However, even though it is low-temperature crystallization, heating at 200°C or higher is required, and therefore many plastic substrates will deform. For this reason, there is a problem of lacking versatility.

As a technique to obtain photocatalytic performance with film formation at room temperature using a general-purpose sputtering device, there is a method for forming a titanium oxide film after forming a zirconium oxide film as an underlayer as shown in Patent Document 5. This method can be said to be an excellent technique that can achieve photocatalytic performance without performing heat treatment.

However, the film formation rate of zirconium oxide is extremely slow, and the degree of crystallization of zirconium oxide is also low, and therefore a certain film thickness is required for zirconium oxide to function sufficiently as an underlayer. In addition, productivity is low in combination with the low film formation rate.

The present invention has been made to solve the relevant problems, and an object thereof is to provide a photocatalyst with high industrial productivity by exploring an underlayer different from zirconium oxide.

### Solution to Problem

The present inventors have conducted extensive studies on such issues, thus leading to realization of the present invention. In other words, by using cerium oxide as an underlayer, a cerium oxide layer crystallized at a high film formation rate and with a significantly thin film thickness could be formed, and a titanium oxide layer formed on top of the cerium oxide layer could be given significantly high photocatalytic performance without heat treatment.

Specifically, for example, an underlayer containing cerium oxide (CeO₂) or cerium oxide and other elements, which do not exceed 10 atomic% relative to elemental cerium of cerium oxide, is formed. Next, a photocatalyst layer containing titanium oxide (TiO₂) or titanium oxide and other elements, which do not exceed 10 atomic% relative to elemental titanium in titanium oxide, is formed. As a result, it has been found that the photocatalyst layer exhibits photocatalytic performance without heat treatment.

It is desirable that an underlayer of the present invention be composed solely of cerium oxide, but other elements may be included as long as the crystallinity of cerium oxide can be maintained. In particular, during sputtering, a composite target may be formed by mixing cerium oxide with other metals to achieve stable discharge. In this case, it is acceptable if the crystallinity of cerium oxide can be maintained, even if a metal is incorporated into a film during film formation. The thickness of the underlayer is not particularly restricted, and it has been found that even 10 nm is effective, for example. However, when a substrate is a plastic film or the like, its surface may not be smooth. Therefore, it is desirable that the thickness of the underlayer be 20 nm or more. If the thickness of the underlayer is 20 nm or more, the continuity of the underlayer can be ensured and sufficient crystallinity can be maintained. However, if the thickness of the underlayer exceeds 100 nm, not only is a thermal load applied to the substrate, but also the process is industrially inefficient. Therefore, the thickness thereof is desirably 100 nm or less.

A photocatalyst layer of the present invention is composed of titanium oxide (TiO₂), but other elements may be contained in addition to titanium oxide as long as photocatalytic performance is exhibited. For example, titanium oxide has a band gap in the ultraviolet region and requires ultraviolet light to function as a photocatalyst, but there are examples where nitrogen has been added to make it responsive to visible light. In the present invention, nitrogen can also be added to form a visible light-responsive photocatalyst. In addition, a metal element, such as niobium, may be added to enhance electrical conductivity of the photocatalyst layer. The thickness of the photocatalyst layer is not particularly limited, and is preferably 20 nm or more for photocatalytic performance to be clearly exhibited. In addition, even if the thickness of the photocatalyst layer is thick, the effect of the present invention can be obtained, but it is desirable industrially that the thickness thereof be 200 nm or less.

Furthermore, the present invention may include layers other than the underlayer and the photocatalyst layer. For example, to maintain the superhydrophilicity of the photocatalyst, a silicon oxide film may be formed on the surface of the photocatalyst layer. In addition, as seen in the Honda-Fujishima effect, a conductive layer may be formed before forming the underlayer to use the present invention as a photocatalytic electrode.

In any case, the present invention is completed by forming a photocatalyst layer containing titanium oxide on a side of the underlayer containing cerium oxide opposite to the substrate. The gist of the present invention is as follows.

According to one aspect of the present invention, provided is a photocatalyst member in which a photocatalyst layer is formed on a substrate via an underlayer, the underlayer contains at least cerium oxide, and the photocatalyst layer contains at least titanium oxide.

Here, the underlayer may be composed solely of the cerium oxide or composed of the cerium oxide and at least one or more other elements at 10 atomic% or less of an elemental cerium proportion.

In addition, the photocatalyst layer may be composed solely of the titanium oxide or composed of the titanium oxide and at least one or more other elements at 10 atomic% or less of an elemental titanium proportion.

In addition, the thickness of the underlayer may be 10 nm or more.

In addition, the thickness of the photocatalyst layer may be 20 nm or more.

The photocatalyst member may include a hydrophilic retention layer in which silicon oxide or a composite oxide of the silicon oxide and another metal is used, on the photocatalyst layer.

In addition, the substrate may be transparent.

In addition, the substrate may be a polymer film.

### Advantageous Effects of Invention

According to the present invention, it is possible to produce a highly productive photocatalyst industrially.

### BRIEF DESCRIPTION OF DRAWINGS

[FIG. 1] A graph illustrating an example of an XRD spectrum.
[FIG. 2] A cross-sectional view illustrating an outline of a photocatalyst member according to the present invention.

### DESCRIPTION OF EMBODIMENT

### <1. Comparison between cerium oxide and zirconium oxide>

The cerium oxide used in the present invention is shown in comparison with the zirconium oxide used in Patent Document 5. First, crystallinity will be compared between the materials when the materials are formed into a film.

An RF sputtering device is used for film formation. An evacuation system consists of a turbomolecular pump and a rotary pump and can perform evacuation until the pressure reaches 5×10⁻⁴ Pa or less. Four cathodes are arranged inside a vacuum chamber, and it is possible to install a target material with a diameter of 2 inches on each of them. A shutter mechanism is installed between the cathodes, and the opening and closing times can be controlled by a timer. Therefore, if the film formation rate is known in advance, the film thickness can be precisely controlled by controlling the shutter opening time. The vacuum chamber is connected to a gas supply pipe, which can supply argon gas, oxygen gas, and nitrogen gas. The flow rate of each gas can be controlled by a mass flow meter installed between a gas cylinder and the vacuum chamber. A conductance valve is installed between the turbomolecular pump and the vacuum chamber, allowing the evacuation rate to be adjusted to achieve an arbitrary film formation pressure. A substrate can be installed on a stage facing the target. The stage can rotate to make the membrane thickness uniform, and it can also be heated up to 300°C. Furthermore, the distance between the stage and the target can also be adjusted.

After installing a silicon substrate on a stage in the above-described RF sputtering device, evacuation was performed until the pressure reached 5×10⁻⁴ Pa or less, and argon gas and oxygen gas were introduced. The ratio of argon gas to oxygen gas was determined by previously investigating the conditions under which no absorption occurs in the visible light region.

For formation of a cerium oxide film, cerium oxide sintered and formed into a target shape was used as a target. Zirconium oxide was used with metallic zirconium as a target. In general, it is known that the film formation rate of a metal target is faster than that of an oxide target.

200 W of RF power was applied to a 2-inch target to form a film on the silicon substrate for a certain period of time, and then film thickness was evaluated through spectroscopic ellipsometry (with an M-2000 manufactured by J. A. Woollam Co., Inc.). In ellipsometry, a phase difference Δ and an amplitude ratio ψ of p-polarized light and s-polarized light are obtained for each wavelength. If an appropriate optical model is applied to these values and fitting is performed also including the film thickness as a parameter, the film thickness can be obtained along with the optical constants. The film thickness was based on measurement results at a central portion of the silicon substrate. The film thickness divided by the film formation time is shown in Table 1.

**[Table 1]**

| Material | Film formation rate |
|---|---|
| Zirconium oxide | 0.3 Å/sec. |
| Cerium oxide | 0.7 Å/sec. |

As is clear from Table 1, it can be seen that cerium oxide has more than twice the film formation rate compared to zirconium oxide.

Furthermore, to compare the crystallinity between materials, films were formed on glass substrates and evaluated through XRD. Alkali-free glass (OA-10G manufactured by Nippon Electric Glass Co., Ltd.) was used to avoid the influence of the substrates in crystallization of the thin films. After washing the substrates with water using a neutral detergent, they were ultrasonically washed in an ethanol solution for 10 minutes. After they were pulled out of the solution, droplets were immediately removed with an air gun to prevent drying stains.

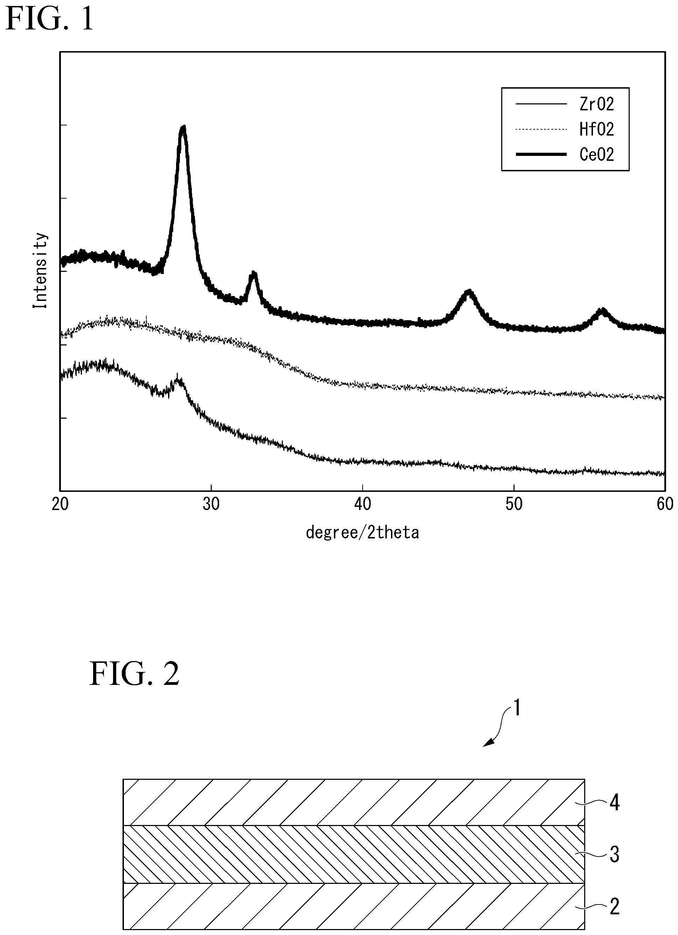

Each washed alkali-free glass was installed on the stage in the above-described RF sputtering device, each film was formed by adjusting the film formation time so that the film thickness was 50 nm based on each film formation rate in Table 1, and the crystallinity was evaluated through XRD. The measurement was performed through XRD using X'Pert Pro MPD (manufactured by PANalytical) with Cuα as a source made to be incident at an incidence angle of 1°. The results of the XRD are shown in FIG. 1.

As shown in FIG. 1, a slight peak is seen around 28° for zirconium oxide. In contrast, cerium oxide has a sharp peak at the same position as well as peaks observed at 33°, 47°, and 56°. Therefore, it can be said that cerium oxide is superior in terms of crystalline surfaces. FIG. 1 also shows results for hafnium oxide for comparison. Hafnium is located directly below zirconium in the periodic table and is expected to have similar properties to zirconium, but it has not crystallized.

The reason why the formation of an underlayer gives titanium oxide photocatalytic performance is thought to be due to partial heteroepitaxial growth. It is thought that a crystal lattice is formed by the underlayer, and titanium oxide is subjected to crystal growth to match its crystallites. Therefore, if the underlayer crystallizes clearly with a thin film thickness, it is thought that crystallization of titanium oxide in the photocatalyst layer formed afterward is also promoted.

Based on the above-described results, a preferred embodiment of the present invention will be described in detail with reference to the drawings.

### <2. Photocatalyst member according to present embodiment>

FIG. 2 is a cross-sectional view schematically illustrating a configuration of a photocatalyst member 1 according to the present invention.

The photocatalyst member 1 according to the present embodiment is a photocatalyst member in which a photocatalyst layer 4 is formed on a substrate 2 via an underlayer 3, the underlayer 3 having at least cerium oxide, and the photocatalyst layer 4 having at least titanium oxide.

### <3. Substrate>

The substrate 2 of the present invention may be composed of any material. Examples of materials for the substrate 2 include glass, a metal, a resin, and ceramics. In particular, resin films with reduced resin thickness have many advantages, such as being lightweight and able to be pasted on various locations. Furthermore, for industrial reasons, when it comes to mass production, there is an advantage of being able to continuously perform film formation using a roll-to-roll sputtering device. Furthermore, transparent resin (polymer) films may also be used in places, such as window glass and displays, where it is necessary to transmit light.

There are no particular limitations on materials for the transparent resin film, but examples thereof include polyethylene terephthalate (PET), polyethylene naphthalate (PEN), polyaramid, polyimide, polycarbonate, polyethylene, polypropylene, triacetyl cellulose (TAC), and polycycloolefin (COC, COP).

The thickness of the substrate 2 is not particularly limited, but is desirably 20 µm to 200 µm when the substrate 2 is a resin film, considering ease of handling during production and thinning of the member. In addition, from the viewpoint of improving abrasion resistance of the substrate 2, a coating of, for example, an acrylic resin can be formed on at least one surface of the substrate 2 through, for example, solution coating. In addition, one obtained by dispersing organic or inorganic particles in the above-described acrylic resin to improve the degree of cloudiness and film runnability may be used.

### <4. Underlayer>

The underlayer 3 is a layer that promotes crystallization of the photocatalyst layer 4, which is an object of the present embodiment. The underlayer 3 contains cerium oxide. More specifically, the underlayer 3 is composed solely of cerium oxide or composed of cerium oxide and at least one or more other elements at a total of 10 atomic% or less of an elemental cerium proportion. However, this configuration is merely an example, and it is sufficient as long as the underlayer 3 contains cerium oxide. Elements contained in the underlayer 3 can be measured by, for example, an X-ray microanalyzer (XMA) or X-ray fluorescence analysis (XRF).

The production method of the underlayer 3 may be any method. However, from the viewpoint of stacking different materials to form a multilayer film, a sputtering method is effective. The thickness of the underlayer is desirably at least 10 nm. In addition, the thickness is desirably 20 nm or more in consideration of the influence of the surface roughness or the like of the substrate 2. The thickness of the underlayer 3 can be measured using a transmission electron microscope by creating a cross-sectional slice of a sample through a microtome method, for example. If the thickness of the underlayer 3 is 20 nm or more, the continuity of the underlayer 3 can be more reliably ensured even if the surface of the substrate 2 is rough. On the other hand, film formation of 100 nm or more not only applies a thermal load on the substrate 2, but also is industrially inefficient. Therefore, 100 nm or less is desirable. The underlayer 3 is desirably composed solely of cerium oxide, but other elements may be incorporated as long as the crystallinity thereof can be maintained. In particular, during sputtering, when a composite target is prepared by mixing cerium oxide with other metals to achieve stable discharge, metals may be incorporated into the film during film formation. Even in such a case, it is sufficient as long as the crystallinity of the underlayer 3 can be maintained. Examples of other metals include Zn and Al.

### <5. Photocatalyst layer>

The photocatalyst layer 4 is a layer that functions as a photocatalyst. The photocatalyst layer 4 contains titanium oxide as a photocatalyst. More specifically, the photocatalyst layer 4 is composed solely of titanium oxide alone, or composed of titanium oxide and at least one or more other elements at a total of 10 atomic% or less of an elemental titanium proportion. However, this configuration is merely an example, and it is sufficient as long as the photocatalyst layer 4 contains titanium oxide to the extent that the effect of the present embodiment can be obtained. Elements contained in the photocatalyst layer 4 can be measured by, for example, an X-ray microanalyzer (XMA) or X-ray fluorescence analysis (XRF).

The production method of the photocatalyst layer 4 may be any method. However, from the viewpoint of stacking different materials to form a multilayer film, a sputtering method is effective. The thickness of the photocatalyst layer 4 is desirably at least 20 nm to make the photocatalyst layer 4 function as a photocatalyst. The thickness of the photocatalyst layer 4 can be measured using a transmission electron microscope by creating a cross-sectional slice of a sample through a microtome method, for example. The upper limit of the thickness thereof is not particularly specified, but is desirably 200 nm or less from the viewpoints of slow film formation rate of titanium oxide and industrial productivity. In the photocatalyst layer 4, other elements may be incorporated as long as the photocatalytic performance is exhibited. For example, titanium oxide has a band gap in the ultraviolet region and requires ultraviolet light to function as a photocatalyst, but there are examples where nitrogen has been added to make it responsive to visible light. In the present invention, nitrogen can also be added to form a visible light-responsive photocatalyst. In addition, a metal element, such as niobium, may be added to enhance electrical conductivity of the photocatalyst layer.

### <6. Other layers>

Here, for the purpose of imparting conductivity to the photocatalyst member 1, one or more layers of conductive material may be stacked between the substrate 2 and the underlayer 3. Examples of such conductive materials include indium-tin composite oxide (ITO) and aluminum-zinc composite oxide (AZO). In addition, metal materials may be stacked. Furthermore, different oxides may be stacked to suppress oxidation by plasma when forming the underlayer 3 on the metal materials. Furthermore, an adhesion layer may be formed for the purpose of ensuring the adhesion between the substrate 2 and the underlayer 3. Furthermore, if the substrate 2 is a transparent substrate, a transparent material may be formed into a film for the purpose of enhancing the transparency of the photocatalyst member 1. Furthermore, a smoothing layer may be formed to smooth the surface of the substrate 2.

Furthermore, a transparent material may be formed on the surface of the photocatalyst layer 4. In particular, a hydrophilic retention layer using silicon oxide or a composite oxide of silicon oxide and other metals may be formed on the photocatalyst layer 4 so that superhydrophilicity can be maintained for a long period of time even in dark places. In addition, since titanium oxide used in the photocatalyst layer is a high refractive index material, a low refractive index material such as silicon oxide may be stacked on the photocatalyst layer for the purpose of reducing the surface reflectance.

As described above, according to the present embodiment, since cerium oxide is used for the underlayer 3, the photocatalytic function of the photocatalyst layer 4 can be exhibited without heating the photocatalyst layer 4. Furthermore, cerium oxide has a fast film formation rate. Accordingly, it is possible to produce a highly productive photocatalyst industrially.

### Examples

Hereinafter, the present invention will be specifically described with reference to examples and comparative examples, but is not limited to the following examples.

### <Example 1>

Alkali-free glass (OA-10G manufactured by Nippon Electric Glass Co., Ltd.) was used as a substrate. After the substrate was washed with water using a neutral detergent, it was ultrasonically washed in an ethanol solution for 10 minutes. After it was pulled out of the solution, droplets were immediately removed with an air gun and dried. The substrate was set in an RF sputtering device, and after evacuation, film formation was performed. A cerium oxide film was formed as an underlayer to a thickness of 50 nm, titanium oxide was stacked thereon to a thickness of 50 nm as a photocatalyst layer, and the stacked body was then taken out to prepare a sample.

### <Example 2>

A sample was prepared under the same conditions as in Example 1 except that the thickness of cerium oxide was set to 10 nm.

### <Example 3>

A sample was prepared under the same conditions as in Example 1 except that the thickness of cerium oxide was set to 100 nm.

### <Example 4>

A sample was prepared under the same conditions as in Example 1 except that the thickness of titanium oxide was set to 20 nm.

### <Example 5>

A sample was prepared under the same conditions as in Example 1 except that the thickness of cerium oxide was set to 200 nm.

### <Example 6>

After preparing a sample under the same conditions as in Example 1, the sample was used as it was to form a silicon oxide film with a thickness of 5 nm using a sputtering device.

### <Example 7>

A cycloolefin polymer (COP) was used as a substrate. Before installing the substrate in a sputtering device, the surface of the COP was exposed to argon plasma at 5 W for 60 seconds using a vacuum device capable of performing a plasma treatment to remove surface contamination, and then the substrate was immediately set in the sputtering device. A sample was then prepared under the same conditions as in Example 1.

### <Comparative Example 1>

Alkali-free glass (OA-10G manufactured by Nippon Electric Glass Co., Ltd.) was used as a substrate. After the substrate was washed with water using a neutral detergent, it was ultrasonically washed in an ethanol solution for 10 minutes. After it was pulled out of the solution, droplets were immediately removed with an air gun and dried to prepare a sample.

### <Comparative Example 2>

Alkali-free glass (OA-1 0G manufactured by Nippon Electric Glass Co., Ltd.) was used as a substrate. After the substrate was washed with water using a neutral detergent, it was ultrasonically washed in an ethanol solution for 10 minutes. After it was pulled out of the solution, droplets were immediately removed with an air gun and dried. The substrate was set in an RF sputtering device, and after evacuation, a titanium oxide film of 50 nm was formed and then taken out to prepare a sample.

### <Comparative Example 3>

A sample prepared under the same conditions as in Comparative Example 2 was heated to 300°C in an electric furnace and then held for 2 hours. Thereafter, the heating of the electric furnace was stopped and the sample was cooled in the furnace until it returned to room temperature, and then the sample was taken out and prepared.

### <Comparative Example 4>

A sample was prepared under the same conditions as in Example 1 except that cerium oxide was replaced with zirconium oxide.

### <Comparative Example 5>

A sample was prepared under the same conditions as in Comparative Example 4 except that the thickness of zirconium oxide was set to 10 nm.

### <Comparative Example 6>

A sample was prepared under the same conditions as in Example 1 except that cerium oxide was replaced with hafnium oxide.

### <Evaluation>

### <Superhydrophilicity evaluation>

Each prepared sample was left in a dark place for 48 hours to eliminate the influence of external light. Thereafter, the sample was taken out and installed in a Xenon Accelerated Weathering Tester Q-SUN Xe-3 (manufactured by Q-Lab Corp.). Xenon light is close to the spectrum of sunlight and the amount of light can be controlled, allowing for accurate verification of the effects of photocatalysts. Irradiation was performed for 1 hour using Daylight-BIB as a filter at an irradiance of 64 W/m² (0.55 W/m²/nm @ 340 nm), a black panel temperature of 70°C, a temperature of 47°C, and a relative humidity of 50%. After taking out the sample, the contact angle of water was evaluated within 30 minutes to evaluate the presence or absence of superhydrophilicity. The contact angle of water was measured using a fully automatic contact angle meter DMo-702 (manufactured by Kyowa Interface Science Co., Ltd.) by dropping 1.5 µL of pure water. The measurement was repeated three times, and an average value was taken as a contact angle after irradiation.

### <Evaluation Results>

### <Examples 1 to 3>

As is clear from Table 2, when the thickness of cerium oxide is in the range of 10 to 100 nm and the thickness of titanium oxide is 50 nm, the contact angles after xenon light irradiation are all 10° or less, indicating that the samples are in a superhydrophilic state and function as photocatalysts.

### <Examples 4 and 5>

Compared to Examples 1 to 3, even when the thicknesses of titanium oxide are set to 20 nm and 200 nm respectively, the contact angles after xenon light irradiation are all 10° or less, indicating that the samples are in a superhydrophilic state and function as photocatalysts.

### <Example 6>

Even if a silicon oxide layer, which is a hydrophilic retention layer, is formed on the surface, the contact angle after xenon light irradiation is 10° or less, indicating that the sample is in a superhydrophilic state and functions as a photocatalyst.

### <Example 7>

The glass transition point of COP is 150°C, but it can be seen that the sample after film formation has not been exposed to high temperatures and has not undergone deformation or the like. The contact angle after xenon light irradiation is 10° or less, indicating that the sample is in a superhydrophilic state and functions as a photocatalyst.

### <Comparative Example 1>

It can be seen that the contact angle in the glass substrate alone does not become 10° or less after xenon light irradiation, whereby the photocatalytic performance is not exhibited.

### <Comparative Example 2>

When only a titanium oxide film is formed at room temperature without heat treatment, the contact angle after xenon light irradiation does not become 10° or less, whereby the photocatalytic performance is not exhibited. This makes it clear that the photocatalytic performance is not exhibited just by forming titanium oxide.

### <Comparative Example 3>

When a film formed under the same conditions as in Comparative Example 2 was heat-treated and irradiated with xenon light, the contact angle was 10° or less, whereby the sample was in a superhydrophilic state and the photocatalytic performance was obtained. However, it is clear that high-temperature heat treatment at 300°C is required.

### <Comparative Example 4>

When zirconium oxide was used as an underlayer instead of cerium oxide, the contact angle became 10° or less upon xenon light irradiation, whereby the sample was in a superhydrophilic state and the photocatalytic performance was obtained. However, as shown in Table 1, the film formation rate of zirconium oxide is slower than that of cerium oxide, resulting in lower productivity.

### <Comparative Example 5>

When zirconium oxide is thinned to 10 nm to reduce the influence of the slow film formation rate, the contact angle after xenon light irradiation does not become 10° or less, whereby the photocatalytic performance is not exhibited. In contrast, as shown in Example 2, cerium oxide exhibits photocatalytic performance even with a thin film thickness, indicating its superiority over zirconium oxide.

### <Comparative Example 6>

When hafnium oxide is used as an underlayer instead of cerium oxide, the contact angle after xenon light irradiation does not become 10° or less, whereby photocatalytic performance is not exhibited. From this, it can be seen that cerium oxide of the present invention is suitable as an underlayer for exhibiting photocatalytic performance.

As described above, according to the present embodiment, it is possible to provide a photocatalyst member that exhibits high productivity without heat treatment. The present embodiment can provide a photocatalyst member used for sterilization of viruses and pathogens, decomposition of formaldehyde causing sick house syndrome, and anti-fogging films.

Furthermore, by applying the present embodiment to an optical film that utilizes a light interference effect, it is possible to impart a function that decomposes organic substances such as sweat and always maintain excellent optical characteristics.

**[Table 2]**

| | Substrate | Underlayer | Thickness of underlayer | Photocatalyst layer | Thickness of photocatalyst layer | Heat treatment conditions | Hydrophilic retention layer | Contact angle after irradiation | Remarks |
|---|---|---|---|---|---|---|---|---|---|
| Example 1 | Glass | CcO₂ | 50 nm | TiO₂ | 50 nm | - | | 5.3 | |
| Example 2 | Glass | CeO₂ | 10 nm | TiO₂ | 50 nm | - | | 5.4 | |
| Example 3 | Glass | CeO₂ | 100 nm | TiO₂ | 50 nm | - | | 6.0 | |
| Example 4 | Glass | CeO₂ | 50 nm | TiO₂ | 20 nm | - | | 4.0 | |
| Example 5 | Glass | CeO₂ | 50 nm | TiO₂ | 200 nm | - | | 4.1 | |
| Example 6 | Glass | CeO₂ | 50 nm | TiO₂ | 50 nm | - | SiO₂, 5 nm | 4.8 | |
| Example 7 | COP | CeO₂ | 50 nm | TiO₂ | 50 nm | - | | 4.4 | |
| Comparative Example 1 | Glass | - | - | - | - | - | | 48.8 | |
| Comparative Example 2 | Glass | - | - | TiO₂ | 50 nm | - | | 34.7 | |
| Comparative Example 3 | Glass | - | - | TiO₂ | 50 nm | 300°C, 2h | | 5.1 | |
| Comparative Example 4 | Glass | ZrO₂ | 50 nm | TiO₂ | 50 nm | - | | 6.5 | |
| Comparative Example 5 | Glass | ZrO₂ | 10 nm | TiO₂ | 50 nm | - | | 10.7 | |
| Comparative Example 6 | Glass | HfO₂ | 50 nm | TiO₂ | 50 nm | - | | 49.9 | |

The suitable embodiment of the present invention is shown in detail in the preceding with reference to the accompanying drawings, but the present invention is not limited to such an example. It is clear that a person of ordinary skill in the art of the invention can conceive of various examples of changes or modifications within the scope of the technical idea described in the claims, and these are naturally understood to fall within the technical scope of the present invention.

## Claims

1. A photocatalyst member in which a photocatalyst layer is formed on a substrate via an underlayer,
wherein the underlayer contains at least cerium oxide, and
wherein the photocatalyst layer contains at least titanium oxide.

2. The photocatalyst member according to claim 1,
wherein the underlayer is composed solely of the cerium oxide or composed of the cerium oxide and at least one or more other elements at 10 atomic% or less of an elemental cerium proportion.

3. The photocatalyst member according to claim 1 or 2,
wherein the photocatalyst layer is composed solely of the titanium oxide or composed of the titanium oxide and at least one or more other elements at 10 atomic% or less of an elemental titanium proportion.

4. The photocatalyst member according to any one of claims 1 to 3,
wherein the thickness of the underlayer is 10 nm or more.

5. The photocatalyst member according to any one of claims 1 to 4,
wherein the thickness of the photocatalyst layer is 20 nm or more.

6. The photocatalyst member according to any one of claims 1 to 5 which includes a hydrophilic retention layer in which silicon oxide or a composite oxide of the silicon oxide and another metal is used, on the photocatalyst layer.

7. The photocatalyst member according to any one of claims 1 to 6,
wherein the substrate is transparent.

8. The photocatalyst member according to any one of claims 1 to 7,
wherein the substrate is a polymer film.
